(19) Europäisches Patentamt
European Patent Office
Office européen des brevets

(11) **EP 3 425 688 A1**

(12) **EUROPÄISCHE PATENTANMELDUNG**

(43) Veröffentlichungstag:
**09.01.2019 Patentblatt 2019/02**

(51) Int Cl.:
***H01L 51/44*** *(2006.01)*

(21) Anmeldenummer: **18180663.9**

(22) Anmeldetag: **29.06.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **06.07.2017 DE 102017115162**

(71) Anmelder: **Jacobs University Bremen gGmbH 28759 Bremen (DE)**

(72) Erfinder:
• **Wagner, Veit**
  **28759 Bremen (DE)**
• **Jovanov, Vladislav**
  **28759 Bremen (DE)**
• **Müller, Arne**
  **28759 Bremen (DE)**

(74) Vertreter: **Weidner Stern Jeschke Patentanwälte Partnerschaft mbB Universitätsallee 17 28359 Bremen (DE)**

(54) **PHOTOSENSOR FÜR EIN DURCHLICHTVERFAHREN UND SPEKTROMETER**

(57) Die Erfindung betrifft einen Photosensor (100), insbesondere Photodiode, für ein Durchlichtverfahren zur Verwendung in einem Spektrometer (201), insbesondere einem Stehende-Welle-Spektrometer. Der Photosensor (100) weist auf: eine erste transparente aktive Schicht (107), welche ein organisches Halbleitermaterial aufweist, wobei eine optische Dicke ($\delta$) der aktiven Schicht (107) so eingestellt ist, dass eine Amplitude ($A_0$) einer positionsabhängigen Komponente einer Intensitätsverteilung einer stehenden Welle hinsichtlich der optischen Dicke ($\delta$) maximal ist.

Fig. 1

**Beschreibung**

Die Erfindung betrifft einen Photosensor, insbesondere eine Photodiode, für ein Durchlichtverfahren zur Verwendung in einem Spektrometer sowie ein optisches Instrument.

Es sind Photosensoren für Spektrometer bekannt, welche auf Basis von Halbleitermaterialien, wie Silizium, hergestellt werden. Solche Photosensoren können alternativ Photodetektoren genannt werden und können zum Beispiel durch Photodioden realisiert werden. Sehr kompakte Spektrometer können dadurch geschaffen werden, dass vor einem Spiegel ein optisch durchlässiger Photosensor beweglich angeordnet ist. Sofern Licht durch den Photosensor auf den Spiegel fällt, bildet sich eine sogenannte stehende (Licht-)Welle vor dem Spiegel aus, welche durch ein Verfahren bzw. Verschieben, beispielsweise mittels Piezoelementen, des Photodetektors abgefragt werden kann, so dass ein Spektrum des Lichts ermittelt werden kann. Solche Vorrichtungen können auch Stehende-Welle-Sensoreinheiten genannt werden.

Aufgrund dessen, dass derartige Photosensoren im Allgemeinen für die abgefragten Wellenlängen durchsichtig sein müssen, besteht ein Zielkonflikt in Bezug auf Ausbeute (Elektronen) und optischer Transparenz. Insbesondere bei Photosensoren nach dem Stand der Technik sind diese im visuellen oder im Infrarotbereich in ihrer Ausbeute beschränkt. Insbesondere der Quotient $\kappa/\eta$ aus dem Imaginärteil des Brechungsindexes und dem Realteil des Brechungsindexes ist bei Photosensoren nach dem Stand der Technik gering. Der Quotient $\kappa/\eta$ wird mit dem griechischen Buchstaben $\beta$ abgekürzt.

Die Druckschrift DE 10 2007 029 822 A1 offenbart ein Interferometer, bestehend aus einer Lichtquelle zur Emission kohärenten Lichts sowie einem Detektor zur Messung der Intensität des Lichts, wobei der Detektor eine Photodiode aus organischem Material ist.

Die Druckschrift WO 2006/077476 A1 offenbart eine Photodiode zur Messung ultrakurzer Pulse im sichtbaren und ultravioletten Bereich mit mindestens zwei Elektroden und einer Schicht aus Polydioctylfluoren (PFO), wobei eine Elektrode vorzugsweise eine Schicht aus Indium-Zinn-Oxid (ITO) aufweist und eine andere Elektrode Schichten aus Calcium und Aluminium umfasst.

Die Druckschrift US 2013/0277669 A1 offenbart eine optoelektronische Vorrichtung mit einer elektronentransportierenden Schicht, welche Zinkoxid und ein Benetzungsmittel umfasst, wobei das Benetzungsmittel 2-(Perfluoralkyl)-Ethanol oder Polyethylenglykol-p-(1,1,3,3-tetramethylbutyl)-Phenylether ist.

Das grundsätzliche Realisieren einer stehenden Welle vor einer reflektierenden Oberfläche, wie z.B. einem Spiegel, kann beispielsweise der DE 10 127 017 B4 entnommen werden, deren diesbezüglicher Inhalt Bestandteil der vorliegenden Anmeldung ist. Zudem ist das Grundprinzip des Aufbaus von Photosensoren der Druckschrift DE 40 172 01 A1 zu entnehmen, deren diesbezüglicher Inhalt ebenfalls Bestandteil dieser Anmeldung ist.

Aufgabe der Erfindung ist es, den Stand der Technik zu verbessern.

Gelöst wird die Aufgabe durch einen Photosensor gemäß Anspruch 1. Vorteilhafte Ausgestaltungen ergeben sich aus den diesbezüglichen Unteransprüchen.

Weiterhin wird die Aufgabe gelöst durch ein optisches Instrument gemäß Anspruch 13, wobei sich eine vorteilhafte Ausgestaltung gemäß Anspruch 14 ergibt.

Der Photosensor zur Verwendung in einem Spektrometer kann insbesondere in einem Stehende-Welle-Spektrometer verwendet werden. Der Photosensor weist eine transparente aktive Schicht auf, welche ein organisches Halbleitermaterial aufweist oder bevorzugt aus einem solchen besteht. Unter dem Begriff transparent wird auch der Begriff semitransparent verstanden. Die aktive Schicht wird vorliegend auch erste Schicht genannt.

Eine optische Dicke der aktiven Schicht ist hierbei so eingestellt, dass eine Amplitude einer positionsabhängigen Komponente einer Intensitätsverteilung einer stehenden Welle hinsichtlich der optischen Dicke maximal ist.

Die optische Dicke ist gegeben durch das Produkt aus dem Realteil des Brechungsindexes und der Dicke der jeweiligen vom Licht durchlaufenen Schicht. Somit gilt die Formel $\delta = \eta \cdot d$, wobei $\delta$ die optische Dicke und $d$ die physikalische Dicke oder Länge der jeweiligen Schicht ist.

Ein Fachmann könnte erwarten, dass die Lichtausbeute sich mit einer Erhöhung der Dicke, also auch der optischen Dicke, der aktiven Schicht stetig erhöht. Insofern würde ein solcher Fachmann nicht davon ausgehen, dass eine optimale Dicke der aktiven Schicht existiert. Überraschenderweise ist es jedoch so, dass die Amplitude und insofern auch die Intensität der positionsabhängigen Komponente der Intensitätsverteilung der stehenden Welle sich als eine Funktion schreiben lässt, welche lediglich von den Variablen Wellenlänge, optische Dicke und dem Quotienten $\beta$ abhängt. Hierbei ist es weiterhin überraschend, dass es nur eine einzige solche optische Dicke gibt, bei welcher die Amplitude der positionsabhängigen Komponente der Intensitätsverteilung der stehenden Welle maximal ist.

Bei einer Stehende-Welle-Sensoreinheit und einem Stehende-Welle-Spektrometer bildet sich eine optische stehende Welle, nachdem eine Lichtquelle von einem Spiegel in sich selbst zurückgeworfen wird und sich somit die einlaufende und die auslaufende Welle überlagern. Die auslaufende Welle weist gegenüber der einlaufenden Welle eine Phasenverschiebung von $\pi$ auf. Unter der Annahme, dass der Spiegel die eintreffende Welle perfekt reflektiert ergibt sich die Intensität der stehenden Welle ($I_s$) zu:

$$I_s = 2 \cdot I_0 - 2 \cdot I_0 \cdot \cos\left(\frac{4\pi}{\lambda} \cdot z_m\right)$$

Hierbei ist $I_0$ die Intensität des Eingangslichts, $\lambda$ die Wellenlänge des Lichtes, und $z_m$ der Abstand vom Spiegel. Diese Gleichung zeigt, dass die Intensität der stehenden Welle eine Summe einer konstanten (DC-)Komponente und einer positionsabhängigen (AC-)Komponente ist, welche eine Information über die Wellenlänge des einfallenden Lichts enthält. Der semitransparente Detektor ist die Schlüsselkomponente bei der Realisierung von Stehende-Welle-Sensoreinheit und erfüllt folgende Anforderungen: Er ist ausreichend transparent, so dass das Licht hindurchtreten und eine stehende Welle bilden kann. Ferner ist die optische Dicke ein Bruchteil der Wellenlänge des Lichts, so dass der erzeugte Strom durch das Muster der stehenden Welle moduliert wird. Um Wellenlängeninformationen zu erhalten, ist die Dicke des Detektors groß genug, so dass die positionsabhängige (AC-)Komponente des in der Sensoreinheit erzeugten Stroms genau gemessen werden kann. Aufgrund dieser Kompromisse ist das Design des semitransparenten Detektors äußerst wichtig, wobei der Schwerpunkt auf Schichtdicken und Materialien für die Herstellung liegt.

Die Qualität eines Stehende-Welle-Spektrometers hängt von den optischen Eigenschaften und dem Design des semitransparenten Detektors ab. Zur Optimierung des semitransparenten Detektors stehen verschiedene Ansätze zur Verfügung. Um diese Optimierungsansätze zu präsentieren wird ein einfaches Modell des Stehwellenspektrometers verwendet. Hierbei wird der semitransparente Detektor nur durch die aktive Schicht mit einer Dicke d und dem komplexen Brechungsindex N= $\eta$ - $i$ · $\kappa$ dargestellt, wobei $\eta$ der Realteil des Brechungsindexes und $\kappa$ der Imaginärteil des Brechungsindexes ist, welcher auch Extinktionskoeffizient genannt wird. Unter der Annahme, dass die Reflexion an den Detektorgrenzflächen vernachlässigt werden kann, was durch geeignete Breitband-Antireflexionsbeschichtungen erreicht werden kann, und der Silberspiegel perfekt reflektierend ist, kann der von einem semitransparenten Detektor bei Beleuchtung mit monochromatischem Licht erzeugte Strom wie folgt ausgedrückt werden:

$$I_{ph} = I_{ph0} \cdot \left[\left(1 - e^{-2\cdot\alpha\cdot d}\right) - \frac{\lambda}{\pi \cdot \eta} \cdot \alpha \cdot e^{-\alpha\cdot d} \cdot \sin\left(\frac{2\pi}{\lambda} \cdot \eta \cdot d\right) \cdot \cos\left(\frac{2\pi}{\lambda} \cdot \eta \cdot d + \frac{4\pi}{\lambda} \cdot z_m\right)\right]$$

Hierbei ist $I_{ph0}$ der erzeugten Strom, wenn das gesamte einfallende Licht vom Detektor absorbiert wird, und $\alpha$ der Absorptionskoeffizient der aktiven Schicht ( $\alpha = \frac{4\pi\kappa}{\lambda}$ ). Der von dem semitransparenten Detektor aufgrund des stehenden Wellenmusters erzeugte Strom besteht aus einer konstanten (DC-) und einer positionsabhängigen (AC-) Komponente analog zur oben dargestellten Gleichung. Die relative Amplitude der Wechselstromkomponente ist durch den folgenden Ausdruck gegeben:

$$A_0 = 2 \cdot \frac{\sin\left(\frac{2\pi}{\lambda} \cdot \eta \cdot d\right)}{\frac{2\pi}{\lambda} \cdot \eta \cdot d} \cdot \alpha \cdot d \cdot e^{-\alpha\cdot d}$$

Durch Verwendung der beiden Gleichungen $\delta$ = $\eta \cdot d$ und $\beta = \frac{\kappa}{\lambda}$, kann die Gleichung umgeschrieben werden zu:

$$A_0 = 4 \cdot \sin\left(\frac{2\pi}{\lambda} \cdot \delta\right) \cdot \beta \cdot e^{-\frac{4\pi}{\lambda}\cdot\delta\cdot\beta}$$

Durch Differenzieren dieses Ausdrucks nach der optischen Dicke $\delta$, erhält man den folgenden Ausdruck für den optimalen Wert für die optische Dicke $\delta$:

$$\delta_{opt} = \frac{\lambda}{2\pi} \cdot \arctan\left(\frac{1}{2 \cdot \beta} \cdot\right)$$

Somit ergibt sich, dass die optische Dicke der aktiven Schicht bevorzugt durch die oben genannte Formel gegeben ist.
Durch die vorliegende Erfindung hat sich überraschend ergeben, dass der Quotienten $\beta$ durch die Verwendung

von organischen Halbleitermaterialien anstelle von bekannten Halbleitermaterialien deutlich erhöht ist. Dies erhöht die Empfindlichkeit des Photosensors insbesondere im Bereich des sichtbaren Lichtes, also insbesondere zwischen 400 nm und 780 nm, und dem Infrarotbereich, also insbesondere bei Wellenlängen größer als 780 nm, deutlich. Weiterhin können somit sehr kompakte optische Spektrometer hergestellt werden.

Ferner kann die Auflösungsfähigkeit und Sensibilität dadurch erhöht werden, dass vorliegender Photosensor äußerst dünn (klein im Vergleich zur Wellenlänge des Lichts) hergestellt werden kann. Zudem hat sich in der Erfindung überraschend herausgestellt, dass eine Dicke des Photosensors verringert werden kann, da eine große Absorption durch die organischen Halbleitermaterialien erreicht wird.

Mithin können mit der vorliegenden Erfindung ultrakompakte Spektrometer hergestellt werden. Dies ermöglicht grundsätzlich neue Technologien, bei denen Spektrometer eingesetzt werden, welche mit den bisherigen Spektrometern des Standes der Technik aufgrund der Bauraumgröße nicht realisierbar waren. Beispielsweise können Spektrometer bereitgestellt werden, die in Kleidung eingearbeitet sind und dabei Gefahrstoffe oder Umweltparameter ermitteln.

Falls man den optimierten Wert für die optische Dicke in die oben genannte Formel für die relative Amplitude $A_0$ der Wechselstromkomponente einsetzt, so hängt diese lediglich noch von der Wellenlänge Lambda und dem Quotienten $\beta$ ab. Der maximale Wert der Amplitude wird für Werte von $\beta$ größer als 4 angenommen, was zwar nicht mathematisch exakt ist, jedoch eine sehr gute Näherung ist. Jedoch ist der Quotient $\beta$ für gewöhnliche Halbleitermaterialien kleiner als 4, oftmals sogar deutlich kleiner als 4.

Um vorteilhafterweise zu erreichen, dass die relative Amplitude $A_0$ der Wechselstromkomponente größer als die Hälfte des Maximalwertes derselben Amplitude ist, wird vorteilhafterweise der Quotient $\beta$ größer als 0,136 gewählt.

Gemäß einer bevorzugten Ausführungsform weist die erste Schicht als organisches Halbleitermaterial ein Polymer und/oder ein Fulleren auf. Weiter bevorzugt besteht die erste Schicht aus einem organischen Halbleitermaterial, welches ein Polymer und ein Fulleren aufweisen. Gemäß einer Ausführungsform kann das Polymermaterial PV52 das Fullerenmaterial F3 sein. Hierbei ist es weiter bevorzugt, dass das organische Halbleitermaterial aus dem Material PV52:F3 besteht, wobei das Gewichtsverhältnis des Polymers PV52 zu dem Fulleren-Material F3 1 zu 2 beträgt. Dieses Material besonders zur Herstellung von semitransparenten Detektoren für Wellenlängen um 640 nm, da der Quotienten $\beta$ für dieses Material in diesem Bereich deutlich größer ist als der entsprechende Quotient $\beta$ von Silizium.

Gemäß einer weiteren bevorzugten Ausführungsform kann das Polymermaterial P3HT und das Fullerenmaterial PCBM sein. Hierbei ist es weiter bevorzugt, dass das organische Halbleitermaterial aus dem Material P3HT:PCBM besteht. Dieses Material eignet sich besonders zur Herstellung von semitransparenten Detektoren für Wellenlängen um 500 nm, da der Quotienten $\beta$ für dieses Material in diesem Bereich deutlich größer ist als der entsprechende Quotient $\beta$ von Silizium und dem oben genannten organischen Material PV52:F3.

Um die Absorption bei Wellenlängen um 400 nm, 570 nm und 650 nm zu optimieren, liegt die Dicke der ersten Schicht bevorzugt zwischen 180 und 220 nm, und beträgt noch weiter bevorzugt 200 nm.

Der Photosensor weist bevorzugt eine transparente zweite Schicht auf, welche eine Elektronentransportschicht ist. Die Elektronentransportschicht (Electron Transport Layer, ETL) ist eine von mehreren Schichten, aus denen Organische Photodioden (OPD) aufgebaut sind. Die Elektronentransportschicht liegt vor der Kathode und leitet die von der durch Lichtabsorption entstandenen Elektronen des Elektronen-Loch-Paars zur Kathode, wo sie zusammen mit den zur Anode transportierten Löchern als Strom genutzt werden können. Die Elektronentransportschicht ist schichtkontaktierend mit der ersten Schicht ausgestaltet und kann durch Zinkoxyd gebildet werden. Bevorzugt weist die zweite Schicht eine Dicke von 30 nm auf.

Der Photosensor weist bevorzugt eine transparente dritte Schicht auf, welche eine Löchertransportschicht ist.

Die Löchertransportschicht (Hole Transport Layer, HTL) ist ebenso wie die Elektronentransportschicht eine von mehreren Schichten, aus denen Organische Photodioden (OPD) aufgebaut sind. Die Löchertransportschicht liegt vor der Anode und leitet die von der durch Lichtabsorption entstandenen Löcher des Elektronen-Loch-Paars zur Anode, wo sie zusammen mit den zur Kathode transportierten Elektronen als Strom genutzt werden können. Die Löchertransportschicht ist schichtkontaktierend mit der ersten Schicht ausgestaltet und kann durch das Material PEDOT:PSS gebildet werden. Bevorzugt liegt die dritte Schicht auf derjenigen Seite der ersten Schicht, welche der zweiten Schicht gegenüber liegt. Bevorzugt weist die dritte Schicht eine Dicke von 50 nm auf.

Um den Photosensor elektrisch kontaktieren zu können weist der Photosensor eine transparente Kathodenschicht und/oder eine transparente Anodenschicht auf, welche insbesondere schichtkontaktierend mit der zweiten Schicht und/oder mit der dritten Schicht ausgestaltet ist oder sind.

Bevorzugt weist die Anode ein Material mit einer hohen Auftragsarbeit, wie zum Beispiel Silber, auf, oder besteht aus einem solchen.

Um die Semitransparenz des organischen Photosensors zu erreichen, ist die Dicke der transparenten Anodenschicht der bevorzugt kleiner als 15 nm und beträgt noch weiter bevorzugt 10 nm.

Um den Photosensor vorteilhafterweise auf unterschiedliche Oberflächen anbringen zu können, ist der Photosensor biegsam ausgestaltet.

Die verwendete Lichtwellenlänge liegt vorteilhafterweise zwischen 400 nm und 700 nm, weiter bevorzugt zwischen 500 und 700 nm, da die organischen Photosensoren insbesondere in diesem Bereich hohe Werte des Quotienten β aufweisen.

Die Transparenz des Photosensors beträgt, insbesondere für eine Wellenlänge zwischen 400 nm und 700 nm, mindestens 20%. Hierdurch wird vorteilhafterweise gewährleistet, dass die stehende Welle stabil ausgebildet wird.

Weiterhin wird die Aufgabe gelöst durch ein optisches Instrument, insbesondere ein optisches Spektrometer, welches einen oben beschriebenen Photosensor aufweist.

Bevorzugt weist das optisches Spektrometer ferner auf: einen Spiegel und eine Verschiebeeinrichtung, wobei der Spiegel oder der Photosensor an der Verschiebeeinrichtung angeordnet ist, so dass durch ein Verschieben ein Spektrum ermittelbar ist.

Um semitransparente Photodetektoren herzustellen, kann ein Design von organischen Solarzellen in einer invertierten Konfiguration modifiziert werden. Dazu wird ein Metall mit einer hohen Austrittsarbeit wie z.B. Silber als Anodenkontakt verwendet. Die invertierte Konfiguration kann gewählt werden, da sie für eine längere Lebensdauer und eine bessere Stabilität der Bauelemente von Vorteil ist, wie bereits für organische Solarzellen gezeigt wurde.

Um die Semitransparenz von organischen Photodetektoren zu erreichen, wurde die Dicke des Silberanodenkontakts von 100 nm, was für organische Solarzellen üblicherweise verwendet wird, auf 10 nm reduziert. Aufgrund der niedrigen Dielektrizitätskonstanten von organischen Materialien ist die Coulomb-Wechselwirkung ausgeprägt, was zu einer hohen Energieabgabe von durch Licht erzeugten Exzitonen führt. Die Exzitonen-Dissoziation wird durch die Kombination von Elektronendonator- und Elektronenakzeptormaterial mit geeigneter Energiedifferenz ermöglicht, um die Exzitonenbindungsenergie zu überwinden. An der Grenzfläche zwischen Donator und Akzeptor findet eine Dissoziation statt und freie Ladungsträger entstehen. Die aktive Schicht in nasschemisch hergestellten organischen Photodetektoren und Solarzellen wird als Bulk-Heterojunction (BHJ) aus Donator- und Akzeptormaterialien realisiert, so dass die Grenzfläche zwischen ihren Gebieten vergrößert wird. Nach der Dissoziation der Exzitonen sind freie Elektronen in den Akzeptorgebiet lokalisiert, während freie Löcher in den Donatorgebiet lokalisiert sind. Vorliegend werden das Polymer P3HT und das Fulleren PCBM als Elektronendonator- bzw. Elektronenakzeptormaterialien verwendet. Freie Ladungsträger werden von der aktiven Schicht (P3HT:PCBM) mithilfe einer Elektronentransportschicht (ETL) und einer Lochtransportschicht (HTL) extrahiert und zu ihren jeweiligen Kontakten, d.h. Kathode oder Anode, transportiert. Die Herstellung der semitransparenten Detektoren wird fast vollständig unter Umgebungsbedingungen realisiert. In einem ersten Schritt der Herstellung wird ein Glassubstrat, das mit 180 nm dickem Indiumzinnoxid (ITO) als Kathodenkontakt beschichtet ist, mit Aceton und 2-Propanol gereinigt, gefolgt von 10 Minuten in einem Ultraviolett(UV)-Ozonreiniger, um jeglichen organischen Rückstand zu entfernen. Nach dem Reinigungsschritt wird eine lösungsverarbeitete ETL auf das ITO aufgeschleudert und für 15 min bei 110°C getempert oder ausgehärtet. Die ETL basiert auf einem Zinkoxid (ZnO), welches von einem Sol-Gel stammt. Die Lösung wird durch Lösen von Zinkacetat-Dihydrat in 2-Methoxyethanol und Ethanolamin hergestellt. Die resultierende Dicke der ZnO-Schicht beträgt 30 nm. Die Mischung der aktiven Schicht wird hergestellt, indem das Polymer (P3HT) und das Fulleren (PCBM) in einem nichtchlorierten Lösungsmittel mit einem Gewichtsverhältnis zwischen Polymer und Fulleren von 1 zu 2 gelöst werden. Eine aktive Schicht mit einer Dicke von 200 nm wird auf der ETL durch Rakeln und 3 Minuten langes Tempern bei 75°C aufgetragen. Danach wird eine lösungsverarbeitete HTL mit einer Dicke von 50 nm durch Aufschleudern aufgetragen und für 10 Minuten bei 75°C getempert. Die HTL-Lösung ist eine Mischung aus Poly(3,4-thylendioxythiophen)-Poly (Styrolsulfonat) (PEDOT: PSS) und Zonyl FSN-100. Im letzten Schritt wird ein 10 nm dicker Silberanodenkontakt durch eine Lochmaske gesputtert, um die Semitransparenz der hergestellten Detektoren zu erreichen.

Im Weiteren wird die Erfindung anhand eines Ausführungsbeispiels näher erläutert. Es zeigen

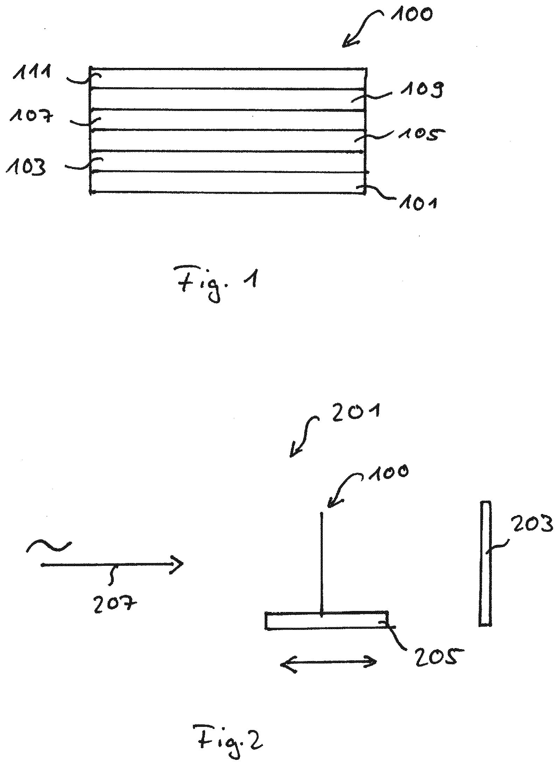

Figur 1     einen schematische Darstellung eines schichtweisen Aufbaus eines Photosensors in einer horizontalen Ausrichtung und

Figur 2     eine stark schematische Darstellung eines Spektrometers mit vertikal ausgerichtetem Photosensor vor einem Spiegel.

Ein Photosensor weist eine Trägerschicht 101 auf, welche durch ein Glas, z.B. Siliziumoxid, gebildet wird. Auf der Trägerschicht 101 ist eine Kathodenkontaktschicht 103 aus Indium-Zinkoxyd (ITO) von einer ungefähren Dicke von 180 nm aufgebracht. Auf der Kathodenkontaktschicht 103 ist eine ca. 30 nm dicke Elektronentransportschicht 105 aufgebracht, zum Beispiel aus nanokristallinem Zinkoxyd (ZnO). Auf der Elektronentransportschicht 105 ist die erste aktive Schicht 107 aufgebracht, welche aus einer ca. 200 nm dicken Schicht des organischen Halbleiters P3HT:PCBM gebildet wird. Auf der aktiven Schicht 107 ist eine ca. 50 nm dicke Löchertransportschicht 109 aus dem organischen Material PEDOT:PPS aufgebracht. Auf der Löchertransportschicht 109 ist eine ca. 10 nm dicke bestehende transparente Anodenkontaktschicht 111 aufgebracht. Die transparente Anodenkontaktschicht 111 kann durch eine Silberbeschichtung realisiert werden.

Die Schichten 103 bis 111 können auch invers aufgebaut sein, so dass auf der Trägerschicht 101 die transparente Anodenkontaktschicht 111, die transparente Löchertransportschicht 109, die aktiven Schicht 107 gefolgt von der transparenten Elektronentransportschicht 105 und abgeschlossen durch die transparente Kathodenkontaktschicht 103 folgt.

In einer weiteren Alternative besteht die Trägerschicht 101 aus einer flexiblen PET-Folie.

Wird nun der Photosensor 100 in einem Spektrometer 201 auf einem verfahrbaren Transportschlitten 205 vertikal angeordnet und vor einem Spiegel 203 angeordnet, so kann einfallendes Licht 207 eine stehende Welle vor dem Spiegel 203 ausbilden, welche durch Verfahren bzw. Verschieben des Transportschlittens 205 und mittels dem Photosensor 100 abgefragt bzw. vermessen werden kann. Somit kann ein Spektrum durch eine entsprechende Auswerteelektronik mit zugehöriger Verstärkung ermittelt werden. Alternativ zur Verwendung von Piezoelementen können feste Spacerlayer mit variabler Dicke, z.B. in Treppen- oder Keilform, zwischen Spiegel und einem Sensor-Array verwendet werden. Hierdurch können vorteilhaftweise beweglichen Teile vermieden werden.

## Patentansprüche

1. Photosensor (100), insbesondere Photodiode, für ein Durchlichtverfahren zur Verwendung in einem Spektrometer (201), insbesondere einem Stehende-Welle-Spektrometer, aufweisend: eine erste transparente aktive Schicht (107), welche ein organisches Halbleitermaterial aufweist, **dadurch gekennzeichnet, dass** eine optische Dicke ($\delta$) der aktiven Schicht (107) derart eingestellt ist, dass eine Amplitude ($A_0$) einer positionsabhängigen Komponente einer Intensitätsverteilung einer stehenden Welle hinsichtlich der optischen Dicke ($\delta$) maximal ist.

2. Photosensor (100) nach Anspruch 1, **dadurch gekennzeichnet, dass** die optische Dicke ($\delta$) der aktiven Schicht (107) gegeben ist durch folgende Formel:

$$\delta = \frac{\lambda}{2\pi} \cdot \arctan\left(\frac{1}{2 \cdot \beta} \cdot\right),$$

wobei $\lambda$ die verwendete Lichtwellenlänge und $\beta$ der Quotient aus dem Imaginärteil ($\kappa$) des Brechungsindexes (N) und dem Realteil ($\eta$) des Brechungsindexes (N) ist.

3. Photosensor (100) nach Anspruch 1 oder 2, **dadurch gekennzeichnet, dass** ein Quotient ($\beta$) aus dem Imaginärteil ($\kappa$) des Brechungsindexes (N) und dem Realteil ($\eta$) des Brechungsindexes (N) größer als 0,136 ist.

4. Photosensor (100) nach einem der vorherigen Ansprüche, **dadurch gekennzeichnet, dass** die aktive Schicht (107) als organisches Halbleitermaterial Polymer P3HT und/oder das Fulleren PCBM aufweist.

5. Photosensor (100) nach einem der vorherigen Ansprüche, ferner aufweisend: eine transparente zweite Schicht (105), wobei die zweite Schicht (105) eine Elektronentransportschicht ist und insbesondere durch Zinkoxyd gebildet wird, wobei die zweite Schicht (105) schichtkontaktierend mit der aktiven Schicht (107) ausgestaltet ist.

6. Photosensor (100) nach einem der vorherigen Ansprüche, ferner aufweisend: eine transparente dritte Schicht (109), wobei die dritte Schicht (109) eine Löchertransportschicht ist und insbesondere durch eine Mischung von PEDOT:PSS und Zonyl FSN-100 gebildet wird, wobei die dritte Schicht (109) schichtkontaktierend mit der ersten Schicht (107) ausgestaltet ist, insbesondere auf derjenigen Seite der ersten Schicht (107), welche der zweiten Schicht (105) gegenüber liegt.

7. Photosensor (100) nach einem der vorherigen Ansprüche, ferner aufweisend: eine transparente Kathodenschicht (103) und/oder eine transparente Anodenschicht (111), welche insbesondere schichtkontaktierend mit der zweiten Schicht (105) und/oder mit der dritten Schicht (109) ausgestaltet ist oder sind.

8. Photosensor (100) nach einem der vorherigen Ansprüche, **dadurch gekennzeichnet, dass** der Photosensor (100) biegsam ausgestaltet ist.

9. Photosensor (100) nach einem der vorherigen Ansprüche, **dadurch gekennzeichnet, dass** eine Dicke der ersten Schicht (107) zwischen 180 und 220 nm liegt.

10. Photosensor (100) nach einem der Ansprüche 7 bis 9, **dadurch gekennzeichnet, dass** eine Dicke der transparenten Anodenschicht (111) kleiner als 15 nm ist.

11. Photosensor (100) nach einem der vorherigen Ansprüche, **dadurch gekennzeichnet, dass** die verwendete Lichtwellenlänge (λ) zwischen 400 nm und 700 nm liegt.

12. Photosensor (100) nach einem der vorherigen Ansprüche, **dadurch gekennzeichnet, dass** eine Transparenz des Photosensors (100) insbesondere für eine Wellenlänge zwischen 400 nm und 700 nm, mindestens 20% beträgt.

13. Optisches Instrument (201), insbesondere optisches Spektrometer (201), welches einen Photosensor (100) nach einem der vorherigen Ansprüche aufweist.

14. Optisches Instrument (201) nach dem vorhergehenden Anspruch ferner aufweisend: einen Spiegel (203) und eine Verschiebeeinrichtung (205), wobei der Spiegel (203) oder der Photosensor (100) an der Verschiebeeinrichtung (205) angeordnet ist, so dass durch ein Verschieben ein Spektrum ermittelbar ist.

111
100
109
107
105
103
101

Fig. 1

201
100
203
207
205

Fig. 2

Europäisches
Patentamt

European
Patent Office

Office européen
des brevets

# EUROPÄISCHER RECHERCHENBERICHT

Nummer der Anmeldung

EP 18 18 0663

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,D<br>Y | DE 10 2007 029822 A1 (SIEMENS AG [DE])<br>2. Januar 2009 (2009-01-02)<br>* Absatz [0034] - Absatz [0037];<br>Abbildungen 3-5 *<br>* Absatz [0010] - Absatz [0012] *<br>* Absatz [0032] *<br>----- | 1,3,4,6,<br>7,10-14<br>5,8,9 | INV.<br>H01L51/44 |
| Y | WO 2017/102058 A1 (MERCK PATENT GMBH [DE])<br>22. Juni 2017 (2017-06-22)<br>* Seite 102, Zeile 29 *<br>----- | 5 | |
| Y | US 2017/077429 A1 (HUANG JINSONG [US] ET<br>AL) 16. März 2017 (2017-03-16)<br>* Absatz [0201] *<br>----- | 8 | |
| Y | US 2012/266957 A1 (WANG XIZU [SG] ET AL)<br>25. Oktober 2012 (2012-10-25)<br>* Absatz [0116] *<br>----- | 9 | |
| | | | RECHERCHIERTE SACHGEBIETE (IPC)<br><br>H01L<br>G01J |

Der vorliegende Recherchenbericht wurde für alle Patentansprüche erstellt

| Recherchenort | Abschlußdatum der Recherche | Prüfer |
|---|---|---|
| München | 3. Dezember 2018 | Beierlein, Udo |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes
    Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 18 18 0663

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

03-12-2018

| Im Recherchenbericht angeführtes Patentdokument | Datum der Veröffentlichung | Mitglied(er) der Patentfamilie | Datum der Veröffentlichung |
|---|---|---|---|
| DE 102007029822 A1 | 02-01-2009 | KEINE | |
| WO 2017102058 A1 | 22-06-2017 | CN 108368265 A<br>EP 3390496 A1<br>KR 20180097671 A<br>TW 201736430 A<br>WO 2017102058 A1 | 03-08-2018<br>24-10-2018<br>31-08-2018<br>16-10-2017<br>22-06-2017 |
| US 2017077429 A1 | 16-03-2017 | KEINE | |
| US 2012266957 A1 | 25-10-2012 | KEINE | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007029822 A1
- WO 2006077476 A1
- US 20130277669 A1
- DE 10127017 B4
- DE 4017201 A1